(19) **Europäisches Patentamt / European Patent Office / Office européen des brevets**

(11) **EP 4 676 118 A1**

(12) **EUROPEAN PATENT APPLICATION**
published in accordance with Art. 153(4) EPC

(43) Date of publication:
**07.01.2026 Bulletin 2026/02**

(21) Application number: **23927900.3**

(22) Date of filing: **17.03.2023**

(51) International Patent Classification (IPC):
**H04W 28/06** $^{(2009.01)}$    **H04W 72/04** $^{(2023.01)}$

(52) Cooperative Patent Classification (CPC):
**H04W 28/06; H04W 72/04**

(86) International application number:
**PCT/CN2023/082281**

(87) International publication number:
**WO 2024/192581 (26.09.2024 Gazette 2024/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **XIE, Junwen**
  **Shenzhen, Guangdong 518129 (CN)**
• **MA, Mengyao**
  **Shenzhen, Guangdong 518129 (CN)**
• **MA, Jianglei**
  **Ottawa Ontario 231 (CA)**
• **BI, Xiaoyan**
  **Ottawa Ontario 231 (CA)**

(74) Representative: **Maiwald GmbH**
**Engineering**
**Elisenhof**
**Elisenstrasse 3**
**80335 München (DE)**

(54) **DATA COMPRESSION TRANSMISSION METHOD AND DEVICE**

(57)    This application provides a data compression and transmission method and an apparatus. The method includes: A first communication apparatus performs compression processing on P-dimensional first data, to obtain Q-dimensional second data, where P is an integer greater than 1, and Q is less than P. The first communication apparatus sends the second data to a second communication apparatus, and may use Q-dimensional data in the first data as position information and remaining (P-Q)-dimensional data as value information, to obtain the second data based on the position information and the value information. In this way, efficient data compression is implemented.

[FIG. 3]

**Description**

TECHNICAL FIELD

This application relates to the field of communication technologies, and in particular, to a data compression and transmission method and an apparatus.

BACKGROUND

With increasingly mature technologies such as wireless communication and artificial intelligence (artificial intelligence, AI), an amount of data generated in a communication system, for example, AI model parameter data, sensing data, and point cloud data, is very large. Consequently, communication devices occupy a large quantity of resources to perform data transmission or storage. In view of this, data is compressed before transmission and storage, to save storage resources and improve communication efficiency. However, compression ratios of three-dimensional data and higher-dimensional data are low. Therefore, how to implement efficient data compression and transmission is an urgent problem to be resolved currently.

SUMMARY

Embodiments of this application provide a data compression and transmission method and an apparatus, to implement efficient data compression and transmission.

According to a first aspect, this application provides a data compression and transmission method. The method may be performed by a terminal device or a component in the terminal device, for example, a chip. This is not limited. Alternatively, the method may be performed by a network device or a component in the network device. The method includes: performing compression processing on P-dimensional first data, to obtain Q-dimensional second data, where P is an integer greater than 1, and Q is less than P; and sending the second data.

According to the data compression and transmission method provided in the first aspect, dimension-reduced compression is performed on to-be-transmitted first data, so that storage resources can be saved and communication efficiency can be improved.

In a possible implementation, the compression processing includes: using Q-dimensional data in the first data as position information and remaining (P-Q)-dimensional data as value information, to obtain the second data based on the position information and the value information. A dimension of data may be reduced by using the position information and the value information to represent the data, so that the data can be processed by using a mature technology with a low dimension.

In a possible implementation, the compression processing further includes: obtaining a data form configuration, and representing the second data based on the data form configuration. A data form includes: The position information and the value information are jointly represented by using a first value map. Alternatively, the position information is represented by using a position sequence or a position bitmap, where the position sequence indicates a position at which data exists or a position at which no data exists, and the position bitmap indicates whether each position has value information; and the value information is represented by using a value sequence corresponding to the position information or a second value map in which the corresponding position information is used as coordinates. Due to factors such as data distribution, a performance condition, and a compression degree, the data forms have respective advantages. Different forms are flexibly selected to maximize benefits.

In a possible implementation, the second value map further includes: A position without value information is filled with an interpolated value, to improve compression efficiency. The interpolated value may include: an average value of neighbor values, a left/right/upper/lower neighbor value, or performing weighting calculation on neighbor values.

In a possible implementation, a maximum of N pieces of value information exist at a same position, and N is an integer greater than 1. The data form further includes: The position information and the value information are jointly represented by using N first value maps, where an $i^{th}$ first value map is for recording an $i^{th}$ piece of value information and corresponding position information, and i=1, 2, ..., N. Alternatively, the position information is represented by using N position sequences or position bitmaps, where an $i^{th}$ position sequence or position bitmap is for recording position information of an $i^{th}$ piece of value information, or the position information is represented by using a value information quantity map for recording a value information quantity at each position; and the value information is represented by using N second value maps, where an $i^{th}$ second value map is for recording the $i^{th}$ piece of value information, or the value information is represented by using a value sequence corresponding to the position information, or a part of pieces of value information is represented by using a second value map, and remaining pieces of value information are represented by using value sequences corresponding to the position information.

In a possible implementation, the compression processing further includes: obtaining a quantization manner configuration, a quantization step configuration, and a compression boundary; and performing quantization based on the quantization manner configuration, the quantization step configuration, and the compression boundary. Quantization can reduce a resource occupied to represent each piece of data.

In a possible implementation, the compression boundary is generated based on the first data, and the compression boundary is sent.

In a possible implementation, the compression boundary includes a quantization boundary value for each dimension.

In a possible implementation, the quantization manner configuration includes an indication of uniform quantization or non-uniform quantization for each dimension. Correspondingly, if the quantization manner configuration is the uniform quantization, the quantization step configuration includes a quantization step for each dimension; or if the quantization manner configuration is the non-uniform quantization, the quantization step configuration includes a quantity of quantization regions for each dimension and a quantization step of each region for each dimension.

In a possible implementation, the compression processing further includes: obtaining a projection mode configuration; and performing projection based on the projection mode configuration. Data is converted into a form needed by a scenario or a task, so that compression and transmission efficiency can be improved.

In a possible implementation, the method further includes: obtaining a coding and compression manner configuration, and performing coding and compression on the second data based on the coding and compression manner configuration. Data may be further compressed.

In a possible implementation, the method further includes: dividing the first data into blocks based on a value range of one or more dimensions, to obtain U pieces of block data, where U is an integer greater than 1; and separately performing compression processing on V pieces of block data, where V is less than or equal to U. Different compression manners may be used for different block data, to improve compression efficiency.

In a possible implementation, sending the second data includes: sending base layer data based on a base layer transmission resource, where the base layer data is a part of the second data that does not exceed a size of the base layer transmission resource. Transmission may be performed for a plurality of times through layered transmission when a transmission resource is insufficient.

In a possible implementation, the second data is represented by using L maps or sequences, L is an integer greater than 1, the base layer data includes K maps or sequences, and K is less than or equal to L. The first data may be constructed by transmitting the K maps or sequences at a base layer, without waiting for completion of transmission of all data.

In a possible implementation, sending the second data further includes sending overlay transmission information.

In a possible implementation, the overlay transmission information includes a performance message or an overlay request.

In a possible implementation, sending the second data further includes: sending overlay data based on sending continue signaling, where the overlay data is a part or all of data other than the base layer data in the second data.

In a possible implementation, sending the overlay data further includes compressing the overlay data by using a different configuration.

According to a second aspect, an embodiment of this application provides a data compression and transmission method. The method may be performed by a network device or a component in the network device, for example, a chip. This is not limited. Alternatively, the method may be performed by a terminal device or a component in the terminal device. The method includes: receiving Q-dimensional second data; and constructing first data based on the second data, where the Q-dimensional second data is obtained by performing compression processing on the P-dimensional first data, P is an integer greater than 1, and Q is less than P.

In a possible implementation, the compression processing includes: using Q-dimensional data in the first data as position information and remaining (P-Q)-dimensional data as value information, to obtain the second data based on the position information and the value information.

In a possible implementation, the compression processing further includes: obtaining a data form configuration, and representing the second data based on the data form configuration. A data form includes: The position information and the value information are jointly represented by using a first value map. Alternatively, the position information is represented by using a position sequence or a position bitmap, where the position sequence indicates a position at which data exists or a position at which no data exists, and the position bitmap indicates whether each position has value information; and the value information is represented by using a value sequence corresponding to the position information or a second value map in which the corresponding position information is used as coordinates.

In a possible implementation, the second value map further includes: A position without value information is filled with an interpolated value.

In a possible implementation, a maximum of N pieces of value information exist at a same position, and N is an integer greater than 1. Obtaining the second data based on the position information and the value information further includes: The position information and the value information are jointly represented by using N first value maps, where an $i^{th}$ first value map is for recording an $i^{th}$ piece of value information and corresponding position information, and i=1, 2, ..., N. Alternatively, the position information is represented by using N position sequences and/or position bitmaps, where an $i^{th}$ position sequence or bitmap is for recording position information of an $i^{th}$ piece of value information, or the position information is represented by using a value information quantity map for recording a value information quantity at each position; and the value information is represented by using N second value maps, where an $i^{th}$ second value map is for recording the $i^{th}$ piece of value information, or the value information is represented by using a value sequence corresponding to the position information, or a part of pieces of value information is represented by using a second value map, and remaining pieces of value information are represented by using value sequences corresponding to the position information.

In a possible implementation, the compression processing further includes: obtaining a quantization manner configuration, a quantization step configuration, and a compression boundary; and performing quantization based on the quantization manner configuration, the quantization step configuration, and the compression boundary.

In a possible implementation, the compression boundary is generated based on the first data, and the compression boundary is received.

In a possible implementation, the quantization manner configuration includes an indication of uniform quantization or non-uniform quantization for each dimension. Correspondingly, if the quantization manner configuration is the uniform quantization, the quantization step configuration includes a quantization step for each dimension; or if the quantization manner configuration is the non-uniform quantization, the quantization step configuration includes a quantity of quantization regions for each dimension and a quantization step of each region for each dimension.

In a possible implementation, the compression processing further includes: obtaining a projection mode configuration; and performing projection based on the projection mode configuration.

In a possible implementation, the method further includes: obtaining a coding and compression manner configuration, and performing coding and compression on the second data based on the coding and compression manner configuration.

In a possible implementation, the method further includes: dividing the first data into blocks based on a value range of one or more dimensions, to obtain U pieces of block data, where U is an integer greater than 1; and separately performing compression processing on V pieces of block data, where V is less than or equal to U.

In a possible implementation, base layer data that is sent based on a base layer transmission resource is received, where the base layer data is a part of the second data that does not exceed a size of the base layer transmission resource.

In a possible implementation, the second data is represented by using L maps or sequences, L is an integer greater than 1, the base layer data includes K maps or sequences, and K is less than or equal to L.

In a possible implementation, overlay transmission information is received.

In a possible implementation, the overlay transmission information includes a performance message or an overlay request.

In a possible implementation, whether overlay transmission is needed is determined based on the overlay transmission information or a requirement. If overlay transmission is needed, sending continue signaling or a resource is sent; or if overlay transmission is not needed, transmission terminate signaling is sent, or no operation is performed.

In a possible implementation, overlay data is received, where the overlay data is a part or all of data other than the base layer data in the second data.

For beneficial effects of the data compression and transmission method provided in the second aspect and the possible implementations of the second aspect, refer to beneficial effects brought by the first aspect and the possible implementations of the first aspect. Details are not described herein again.

According to a third aspect, an embodiment of this application provides a communication apparatus. The communication apparatus includes: a processing module, configured to perform compression processing on P-dimensional first data, to obtain Q-dimensional second data, where P is an integer greater than 1, and Q is less than P; and a transceiver module, configured to send the second data.

In a possible implementation, the compression processing includes: using Q-dimensional data in the first data as position information and remaining (P-Q)-dimensional data as value information, to obtain the second data based on the position information and the value information.

In a possible implementation, the compression processing further includes: obtaining a data form configuration, and representing the second data based on the data form configuration. A data form includes: The position information and the value information are jointly represented by using a first value map. Alternatively, the position information is represented by using a position sequence or a position bitmap, where the position sequence indicates a position at which data exists or a position at which no data exists, and the position bitmap indicates whether each position has value information; and the value information is represented by using a value sequence corresponding to the position information or a second value map in which the corresponding position information is used as coordinates.

In a possible implementation, the second value map further includes: A position without value information is filled with an interpolated value, to improve compression efficiency. The interpolated value may include: an average value of neighbor values, a left/right/upper/lower neighbor value, or performing weighting calculation on neighbor values.

In a possible implementation, a maximum of N pieces of value information exist at a same position, and N is an integer greater than 1. The data form further includes: The position information and the value information are jointly represented by using N first value maps, where an $i^{th}$ first value map is for recording an $i^{th}$ piece of value information and corresponding position information, and i=1, 2, ..., N. Alternatively, the position information is represented by using N position sequences and/or position bitmaps, where an $i^{th}$ position sequence or position bitmap is for recording position information of an $i^{th}$ piece of value information, or the position information is represented by using a value information quantity map for recording a value information quantity at each position; and the value information is represented by using N second value maps, where an $i^{th}$ second value map is for recording the $i^{th}$ piece of value information, or the value information is represented by using a value sequence corresponding to the position information, or a part of pieces of value information is represented by using a second value map, and remaining pieces of value information are represented by using value sequences corresponding to the position information.

In a possible implementation, the compression processing further includes: obtaining a quantization manner configuration, a quantization step configuration, and a compression boundary; and performing quantization based on the quantization manner configuration, the quantization step configuration, and the compression boundary.

In a possible implementation, the compression boundary is generated based on the first data, and the transceiver module sends the compression boundary.

In a possible implementation, the compression boundary includes a quantization boundary value for each dimension.

In a possible implementation, the quantization manner configuration includes an indication of uniform quantization or non-uniform quantization for each dimension. Correspondingly, if the quantization manner configuration is the uniform quantization, the quantization step configuration includes a quantization step for each dimension; or if the quantization manner configuration is the non-uniform quantization, the quantization step configuration includes a quantity of quantization regions for each dimension and a quantization step of each region for each dimension.

In a possible implementation, the compression processing further includes: obtaining a projection mode configuration; and performing projection based on the projection mode configuration.

In a possible implementation, the processing module is further configured to: obtain a coding and compression manner configuration; and perform coding and compression on the second data based on the coding and compression manner configuration.

In a possible implementation, the processing module is further configured to: divide the first data into blocks based on a value range of one or more dimensions, to obtain U pieces of block data, where U is an integer greater than 1; and separately perform compression processing on V pieces of block data, where V is less than or equal to U.

In a possible implementation, sending the second data includes: The transceiver module sends base layer data based on a base layer transmission resource, where the base layer data is a part of the second data that does not exceed a size of the base layer transmission resource.

In a possible implementation, the second data is represented by using L maps or sequences, L is an integer greater than 1, the base layer data includes K maps or sequences, and K is less than or equal to L.

In a possible implementation, sending the second data further includes: The transceiver module sends overlay transmission information.

In a possible implementation, the overlay transmission information includes a performance message or an overlay request.

In a possible implementation, sending the second data further includes: The transceiver module sends overlay data based on sending continue signaling, where the overlay data is a part or all of data other than the base layer data in the second data.

In a possible implementation, sending the overlay data further includes compressing the overlay data by using a different configuration.

For beneficial effects of the communication apparatus provided in the third aspect and the possible implementations of the third aspect, refer to beneficial effects brought by the first aspect and the possible implementations of the first aspect. Details are not described herein again.

According to a fourth aspect, an embodiment of this application provides a communication apparatus. The communication apparatus includes: a transceiver module, configured to receive Q-dimensional second data, where the second data is obtained by performing compression processing on P-dimensional first data, P is an integer greater than 1, and Q is less than P; and a processing module, configured to construct the first data based on the second data.

In a possible implementation, the compression processing includes: using Q-dimensional data in the first data as position information and remaining (P-Q)-dimensional data as value information, to obtain the second data based on the position information and the value information.

In a possible implementation, the compression processing further includes: obtaining a data form configuration, and representing the second data based on the data form configuration. A data form includes: The position information and the value information are jointly represented by using a first value map. Alternatively, the position information is represented by using a position sequence or a position bitmap, where the position sequence indicates a position at which data exists or a position at which no data exists, and the position bitmap indicates whether each position has value information; and the value information is represented by using a value sequence corresponding to the position information or a second value map in which the corresponding position information is used as coordinates.

In a possible implementation, the second value map further includes: A position without value information is filled with an interpolated value.

In a possible implementation, a maximum of N pieces of value information exist at a same position, and N is an integer greater than 1. Obtaining the second data based on the position information and the value information further includes: The position information and the value information are jointly represented by using N first value maps, where an $i^{th}$ first value map is for recording an $i^{th}$ piece of value information and corresponding position information, and i=1, 2, ..., N. Alternatively, the position information is represented by using N position sequences and/or position bitmaps, where an $i^{th}$ position sequence or position bitmap is for recording position information of an $i^{th}$ piece of value information, or the position information is represented by using a value information quantity map for recording a value information quantity at each position; and the value information is represented by using N second value maps, where an $i^{th}$ second value map is for recording the $i^{th}$ piece of value information, or the value information is represented by using a value sequence corresponding to the position information, or a part of pieces of value information is represented by using a second value map, and remaining pieces of value information are represented by using value sequences corresponding to the position information.

In a possible implementation, the compression processing further includes: obtaining a quantization manner configuration, a quantization step configuration, and a compression boundary; and performing quantization based on the quantization manner configuration, the quantization step configuration, and the compression boundary.

In a possible implementation, the compression boundary is generated based on the first data, and the transceiver module receives the compression boundary.

In a possible implementation, the quantization manner configuration includes an indication of uniform quantization or non-uniform quantization for each dimension. Correspondingly, if the quantization manner configuration is the uniform quantization, the quantization step configuration includes a quantization step for each dimension; or if the quantization manner configuration is the non-uniform quantization, the quantization step configuration includes a quantity of quantization regions for each dimension and a quantization step of each region for each dimension.

In a possible implementation, the compression processing further includes: obtaining a projection mode configuration; and performing projection based on the projection mode configuration.

In a possible implementation, the processing module is further configured to: obtain a coding and compression manner configuration; and perform coding and compression on the second data based on the coding and compression manner configuration.

In a possible implementation, the processing module is further configured to: divide the first data into blocks based on a value range of one or more dimensions, to obtain U pieces of block data, where U is an integer greater than 1; and separately perform compression processing on V pieces of block data, where V is less than or equal to U.

In a possible implementation, the transceiver module is further configured to receive base layer data that is sent based on a base layer transmission resource, where the base layer data is a part of the second data that does not exceed a size of the base layer transmission resource.

In a possible implementation, the second data is represented by using L maps or sequences, L is an integer greater than 1, the base layer data includes K maps or sequences, and K is less than or equal to L.

In a possible implementation, the transceiver module is further configured to receive overlay transmission information.

In a possible implementation, the overlay transmission information includes a performance message or an overlay request.

In a possible implementation, the processing module is further configured to determine, based on the overlay transmission information or a requirement of the processing module, whether overlay transmission is needed. If overlay transmission is needed, the transceiver module sends sending continue signaling or a resource; or if overlay transmission is not needed, the transceiver module sends transmission terminate signaling, or performs no operation.

In a possible implementation, the transceiver module receives overlay data, where the overlay data is a part or all of data other than the base layer data in the second data.

For beneficial effects of the communication apparatus provided in the fourth aspect and the possible implementations of the fourth aspect, refer to beneficial effects brought by the first aspect and the possible implementations of the first aspect. Details are not described herein again.

According to a fifth aspect, an embodiment of this application provides a communication apparatus. The communication apparatus includes a processor, configured to perform the method in any one of the first aspect, the second aspect, or the possible implementations of the first aspect and the second aspect by running a computer program or by using a logic circuit.

In a possible implementation, the communication apparatus further includes a memory, and the memory is configured to store the computer program.

In a possible implementation, the communication apparatus further includes a communication interface, and the communication interface is configured to input and/or output a signal.

According to a sixth aspect, an embodiment of this application provides a communication system. The communication system includes: a first communication apparatus, configured to perform the method in any one of the first aspect or the possible implementations of the first aspect; and a second communication apparatus, configured to perform the method in any one of the second aspect or the possible implementations of the second aspect.

According to a seventh aspect, an embodiment of this application provides a computer-readable storage medium, configured to store computer program instructions. The computer program enables a computer to perform the method in any one of the first aspect, the second aspect, or the possible implementations of the first aspect and the second aspect.

According to an eighth aspect, an embodiment of this application provides a computer program product, including computer program instructions. The computer program instructions enable a computer to perform the method in any one of the first aspect, the second aspect, or the possible implementations of the first aspect and the second aspect.

According to a ninth aspect, an embodiment of this application provides a computer program. The computer program enables a computer to perform the method in any one of the first aspect, the second aspect, or the possible implementations of the first aspect and the second aspect.

BRIEF DESCRIPTION OF DRAWINGS

FIG. 1 is a diagram of an architecture of a mobile communication system to which an embodiment of this application is applied;

FIG. 2 is a diagram of a framework of data compression and transmission according to an embodiment of this application;

FIG. 3 is a schematic interaction flowchart of a data compression and transmission method according to an embodiment of this application;

FIG. 4 is a diagram of a position bitmap according to an embodiment of this application;

FIG. 5 is a diagram of a first value map according to an embodiment of this application;

FIG. 6 is a diagram of a value information quantity map according to an embodiment of this application;

FIG. 7a is a schematic interaction flowchart of a data compression and transmission method according to an embodiment of this application;

FIG. 7b is a schematic interaction flowchart of a data compression and transmission method according to an embodiment of this application;

FIG. 7c is a schematic interaction flowchart of a data compression and transmission method according to an embodiment of this application;

FIG. 8a is a first diagram of overlay transmission according to an embodiment of this application;

FIG. 8b is a second diagram of overlay transmission according to an embodiment of this application;

FIG. 9 is a block diagram of a communication apparatus according to an embodiment of this application; and

FIG. 10 is another block diagram of a communication apparatus according to an embodiment of this application.

DESCRIPTION OF EMBODIMENTS

The following describes technical solutions of this application with reference to accompanying drawings.

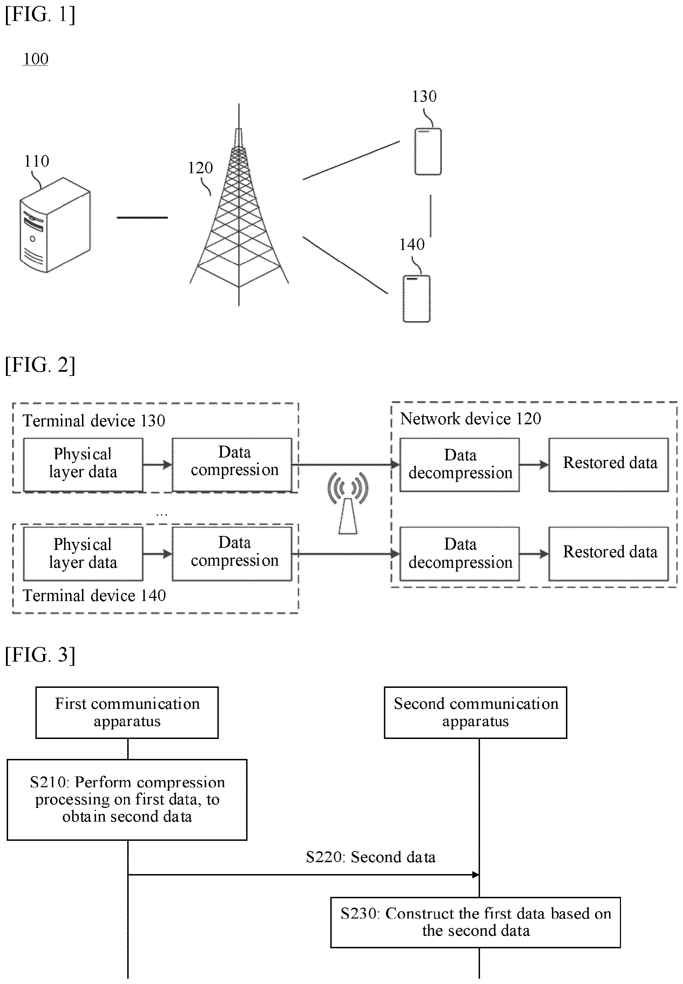

FIG. 1 is a diagram of an architecture of a mobile communication system to which an embodiment of this application is applied. As shown in FIG. 1, the mobile communication system includes a core network device 110, a network device 120, and at least one terminal device (for example, a terminal device 130 and a terminal device 140 shown in FIG. 1). The terminal device is connected to the network device in a wireless manner, and the network device is connected to the core network device in a wireless or wired manner. The core network device and the network device may be different physical devices independent of each other, functions of the core network device and logical functions of the network device may be integrated into a same physical device, or some functions of the core network device and some functions of the network device may be integrated into one physical device. The terminal device may be located at a fixed position, or may be movable. FIG. 1 is merely a diagram. The communication system may further include another network device, for example, may further include a wireless relay device and a wireless backhaul device, which are not shown in FIG. 1. Quantities of core network devices, network devices, and terminal devices included in the mobile communication system are not limited in embodiments of this application.

In embodiments of this application, the network device may be any device with a wireless transceiver function. The network device includes but is not limited to: an evolved NodeB (evolved NodeB, eNB), a home base station (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), or a transmission and reception point (transmission and reception point, TRP). The network device may alternatively be a mobile switching center, a device that undertakes a base station function in device-to-device (Device-to-Device, D2D), vehicle-to-everything (vehicle-to-everything, V2X), or machine-to-machine (machine-to-machine, M2M) communication, or the like. The network device may alternatively be a gNB in a 5G system, or one antenna panel or a group of antenna panels (including a plurality of antenna panels) of a base station in the 5G system. The network device may alternatively be a network node, for example, a BBU or a distributed unit (distributed unit, DU), that constitutes a gNB or a transmission point. This is not specifically limited in embodiments of this application.

In some deployments, the gNB may include a central unit (central unit, CU) and the DU. The CU and the DU each implement some functions of the gNB, and the CU and the DU may communicate with each other through an F1 interface. The gNB may further include an active antenna unit (active antenna unit, AAU). The AAU may implement some physical layer processing functions, radio frequency processing, and a function related to an active antenna.

It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

In embodiments of this application, the terminal device may also be referred to as user equipment (user equipment, UE), an access terminal, a subscriber unit, a subscriber station, a mobile station, a remote station, a remote terminal, a mobile device, a user terminal, a terminal, a wireless communication device, a user agent, or a user apparatus.

The terminal device may be a device that provides a user with voice/data connectivity, for example, a handheld device or a vehicle-mounted device that has a wireless connection function. Currently, some examples of the terminal may be: a mobile phone (mobile phone), a tablet computer (pad), a computer with a wireless transceiver function (such as a notebook computer or a palmtop computer), a customer-premises equipment (customer premises equipment, CPE), a smart point of sale (point of sale, POS) machine, a mobile internet device (mobile internet device, MID), a virtual reality (virtual reality, VR) device, an augmented reality (augmented reality, AR) device, a wireless terminal in industrial control (industrial control), a wireless terminal in self-driving (self-driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device or another processing device connected to a wireless modem, a vehicle-mounted device, a wearable device, a terminal device in a 5G network, a terminal device in a system evolved after 5G, or the like.

Communication between the network device and the terminal device may be performed over a licensed spectrum (licensed spectrum), or may be performed over an unlicensed spectrum (unlicensed spectrum), or may be performed over both a licensed spectrum and an unlicensed spectrum. Communication between the network device and the terminal device may be performed over a spectrum below 6G, or may be performed over a spectrum above 6G, or may be performed over both a spectrum below 6G and a spectrum above 6G. A spectrum resource used by the network device and the terminal device is not limited in embodiments of this application.

It should be understood that specific forms of the network device and the terminal device are not limited in this application.

A communication method provided in this application may be applied to various communication systems, for example, a long term evolution (Long Term Evolution, LTE) system, a 5G mobile communication system, and a mobile communication system evolved after the 5G mobile communication system, for example, a 6G mobile communication system. The 5G mobile communication system or the 6G mobile communication system may include non-standalone (non-standalone, NSA) and/or standalone (standalone, SA) networking.

The communication method provided in this application may be further applied to machine type communication (machine type communication, MTC), a long term evolution-machine technology (Long Term Evolution-machine, LTE-M), a device-to-device (device-to-device, D2D) network, a machine-to-machine (machine-to-machine, M2M) network, an internet of things (internet of things, IoT) network, or another network.

In the communication system shown in FIG. 1, for a process of performing data compression and transmission between devices, refer to a diagram of a framework of data compression and transmission shown in FIG. 2. As shown in FIG. 2, the terminal devices 130 and 140 may separately perform data compression on local data (for example, physical layer data), and then send compressed data to the network device 120. The network device 120 separately performs data decompression on the compressed data that is received from each terminal device, and further performs data restoration for each terminal device, to obtain restored data.

Due to rapid development of technologies such as wireless communication and artificial intelligence, generation and transmission of multidimensional data are to be applied to a wider range of application scenarios in the future. For example, in a near future, there is a significant demand across various fields for storage or interaction of three-dimensional data such as point cloud data, sensing data, and the like. Because data transmission needs to occupy a large quantity of communication resources, each communication device needs to perform data compression during each time of data transmission, to improve communication efficiency and save storage resources.

In recent years, a technology for two-dimensional data compression is increasingly mature, but compression efficiency for three-dimensional data and higher-dimensional data is not high. To improve compression and transmission performance of multidimensional data, in embodiments of this application, compression processing is performed on the multidimensional data, to obtain compressed data that is dimension-reduced. Specifically, a part of dimensions of the multidimensional data may be used as position information, and remaining dimensions are used as value information. The compressed data that is dimension-reduced is obtained based on the position information and data information. After dimension reduction is performed on sparse multidimensional data, the data becomes denser, so that compression efficiency can be improved. In addition, this may be combined with a data coding and compression manner to further improve the compression efficiency.

It should be noted that, the foregoing example only uses uplink data transmission as an example for description, but this should not be understood as any limitation on this application. For example, a network device (for example, 120 in FIG. 1) may perform downlink data transmission to a terminal device (for example, 130 and/or 140 in FIG. 1). Alternatively, a terminal device A (for example, 130 in FIG. 1) may perform sidelink data transmission to a terminal device B (for example, 140 in FIG. 1).

In embodiments of this application, performing data restoration on first data may be expressed as performing data construction on the first data, and meanings to be expressed are the same. In addition, for ease of expression, the meanings are also consistent after a word order is adjusted. For example, the foregoing expression may also be replaced with restoring the first data or constructing the first data.

It may be understood that, in the present invention, the compression processing on the multidimensional data may not be limited to being used for transmission, and may also be used for local storage or other processing.

The following describes the communication method provided in embodiments of this application with reference to the accompanying drawings.

It should be understood that, merely for ease of understanding and description, the following describes the method provided in embodiments of this application by using interaction between a first communication apparatus and a second communication apparatus as an example. When a data compression and transmission method provided in embodiments of this application is applied to uplink transmission, the first communication apparatus may be any terminal device in the communication system shown in FIG. 1, for example, the terminal device 130 or the terminal device 140, and the second communication apparatus may be the network device 120 in the communication system shown in FIG. 1. When the data compression and transmission method provided in embodiments of this application is applied to downlink transmission, the first communication apparatus may be the network device 120 in the communication system shown in FIG. 1, and the second communication apparatus may be any terminal device in the communication system shown in FIG. 1, for example, the terminal device 130 or the terminal device 140. When the data compression and transmission method provided in embodiments of this application is applied to sidelink transmission, the first communication apparatus may be any terminal device in the communication system shown in FIG. 1, for example, the terminal device 130, and the second communication apparatus may be any terminal device other than the first communication apparatus in the communication system shown in FIG. 1, for example, the terminal device 140.

It should be further understood that this should not constitute any limitation on an execution entity of the method provided in this application. Any apparatus may serve as the execution entity of the method provided in embodiments of this application, provided that the apparatus can perform the method provided in embodiments of this application by running a program that includes code of the method provided in embodiments of this application. For example, any one of the foregoing communication apparatuses may be implemented as a terminal device, or may be implemented as a component in the terminal device, for example, a chip, a chip system, or another functional module that can invoke a program and execute the program. Any one of the foregoing communication apparatuses may be implemented as a network device, or may be implemented as a component in the network device, for example, a chip, a chip system, or another functional module that can invoke a program and execute the program.

FIG. 3 is a schematic interaction flowchart of a data compression and transmission method according to an embodiment of this application. With reference to FIG. 3, the method 200 includes some or all of the following processes.

S210: A first communication apparatus performs compression processing on first data, to obtain second data.

S220: The first communication apparatus sends the second data. Correspondingly, a second communication apparatus receives the second data.

S230: The second communication apparatus constructs the first data based on the second data.

The first data is P-dimensional data, the second data is Q-dimensional data, P is an integer greater than 1, and Q is less than P. For example, the first data is three-dimensional data, and the second data is two-dimensional data.

A dimension of data includes a dimension of a spatial position and a dimension of a parameter such as intensity, a color, or a delay. For example, common data collected by a radar includes related attributes such as a position of a point in x, y, and z directions, a scanning vertical/horizontal angle, intensity, a delay, and a color, and may form multidimensional point cloud data. Because the radar collects the data by using evenly distributed light beams, position information of the data may also be represented by using a sequence number of a light beam in a vertical direction and a sequence number of the light beam in a horizontal direction.

The compression processing includes: using Q-dimensional data in the first data as position information and remaining (P-Q)-dimensional data as value information, to obtain the second data based on the position information and the value information. For example, the first data is three-dimensional data, and three dimensions are respectively three spatial position dimensions of x, y, and z. x and y are used as the position information, and z is used as the value information; or quantized values of x and y may be used as the position information, and a quantized value of z may be used as the value information. Alternatively, the first data is four-dimensional data, and four dimensions are respectively three spatial position dimensions of x, y, and z and intensity I. x, y, and z are used as the position information, and I is used as the value information; or x and y may be used as the position information, and z and I may be used as the value information. It may be understood as that the four-dimensional data (x, y, z, I) is split into two pieces of three-dimensional data: (x, y, z) and (x, y, I).

The first communication apparatus obtains a data form configuration that indicates a representation form of the second data. The data form configuration may be pre-agreed upon by the first communication apparatus and the second communication apparatus, or may be pre-sent by the first communication apparatus to the second communication apparatus, or may be pre-sent by the second communication apparatus to the first communication apparatus, or may be defined in a protocol.

The representation form includes the following several types.

The position information and the value information are jointly represented by using a first value map. The value information is filled into a corresponding position in the first value map. A value outside a value range of the value information is assigned to indicate that no value information exists. Alternatively, the position information is represented by using a position sequence or a position bitmap. The position sequence indicates a position at which data exists or a position at which no data exists. When data is sparse, a small amount of data is needed to indicate the position at which data exists, and when data is dense, a small amount of data is needed to indicate the position at which no data exists. The position bitmap indicates whether each position has value information, and coordinates in the position bitmap correspond to the position information. The value information is represented by using a value sequence corresponding to the position information or a second value map in which the corresponding position information is used as coordinates. The value information is filled into a corresponding position in the second value map, and any value may be at a position without the value information in the second value map. Optionally, the position without the value information is filled with an interpolated value. For example, an average value of neighbor values, a left/right/upper/lower neighbor value, or performing weighting calculation on neighbor values is used as the interpolated value.

When a maximum of N pieces of value information exist at a same position (where N is an integer greater than 1), the position information and the value information are jointly represented by using N first value maps. An $i^{th}$ piece of value information is filled into a corresponding position in an $i^{th}$ first value map, and a value outside a value range of the value information is assigned to indicate that no value information exists, where i=1, 2, ..., N. Alternatively, the position information is represented by using N position sequences and/or position bitmaps, where an $i^{th}$ position sequence or position bitmap is for recording position information of an $i^{th}$ piece of value information, or the position information is represented by using a value information quantity map for recording a value information quantity at each position; and the value information may be represented by using N second value maps, where an $i^{th}$ second value map is for recording the $i^{th}$ piece of value information, or the value information may be represented by using a value sequence corresponding to the position information, or a part of pieces of value information is represented by using a second value map, and remaining pieces of value information are represented by using value sequences.

It may be understood that, in a scenario in which a plurality of maps are used for representation, because quantization manners are the same and the position information corresponds to coordinates in the maps, sizes of the maps are also the same. Optionally, a part of the maps is re-quantized based on the position information, so that a part of positions without data information may be removed, and a size of a map decreases, to save storage and transmission resources.

For example, a data form may include the following.

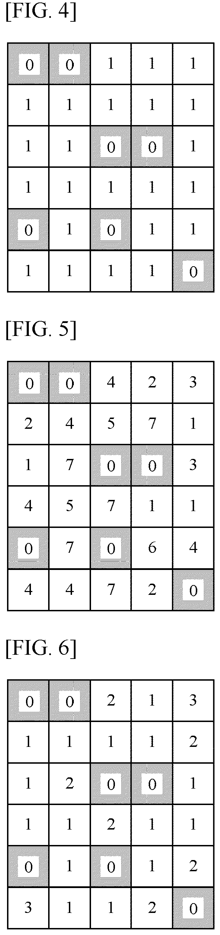

    1. The value information is represented by using a second value map, and the position information corresponds to coordinates in the second value map. A position bitmap indicates whether each position has value information in the second value map. For example, "0" indicates that no value information exists, and "1" indicates that value information exists. Refer to FIG. 4.

2. The value information is represented by using a second value map, and the position information corresponds to coordinates in the second value map. A position sequence formed by position coordinates indicates a position without value information in the second value map, for example, $(\tilde{\theta}_1, \tilde{\varnothing}_1, \tilde{\theta}_2, \tilde{\varnothing}_2, ...)$. When one position corresponds to a plurality of pieces of value information, an $i^{th}$ piece of value information forms an $i^{th}$ second value map, or a part of pieces of value information is represented by using a value sequence.

3. The value information is represented by using a first value map, and the position information corresponds to coordinates in the first value map. A value outside a value range of the value information is assigned to indicate that no value information exists. For example, the value range of the value information is 1 to 7, and 0 indicates that no value information exists. Refer to FIG. 5.

4. A position bitmap corresponding to the position information indicates whether each position has value information. The position bitmap is sequentially traversed, and value information at a corresponding position is represented by using a value sequence, for example, $(\tilde{r}_1, \tilde{r}_2, \tilde{r}_3, ...)$.

5. When one position corresponds to a plurality of pieces of value information, a value information quantity recording map is for recording a value information quantity at each position. Refer to FIG. 6. The value information quantity recording map is sequentially traversed. One or more pieces of value information at a corresponding position are represented by using a value sequence, for example, $(\tilde{r}_{1\_1}, \tilde{r}_{1\_2}, \tilde{r}_{2\_1}, \tilde{r}_{3\_1}, \tilde{r}_{3\_2}, \tilde{r}_{3\_3}, ...)$, or an $i^{th}$ piece of value information is denoted as an $i^{th}$ sequence. For example, $x1=(\tilde{r}_{1\_1}, \tilde{r}_{2\_1}, \tilde{r}_{3\_1}, ...)$, $x2=(\tilde{r}_{1\_2}, \tilde{r}_{2\_2}, ...)$, and $x3=(\tilde{r}_{1\_3}, ...)$.

Due to factors such as data distribution, a performance condition, and a compression degree, the data forms have respective advantages. Different forms are flexibly selected to maximize benefits.

The compression processing may further include quantization, to reduce a resource occupied to represent each piece of data.

The first communication apparatus obtains a quantization manner configuration, a quantization step, and a compression boundary, and performs quantization based on the quantization manner configuration, the quantization step, and the compression boundary.

Specifically, the position information may be quantized from a floating-point number to an integer, to represent coordinates, and the value information may be quantized from a floating-point number to an integer, to reduce a resource occupied by data.

The quantization manner configuration includes an indication of uniform quantization or non-uniform quantization for each dimension. Whether to use the non-uniform quantization is determined based on data distribution in each dimension.

Specifically, one parameter indicates that the uniform quantization or the non-uniform quantization is performed in all dimensions, or each dimension is represented by using one parameter, or each dimension is represented by using a plurality of parameters, where each parameter corresponds to one or more dimensions.

The quantization step includes a quantization step for each dimension. Specifically, for each dimension, if the uniform quantization is performed, a quantization step is included; or if the non-uniform quantization is performed, a quantity of quantization regions for each dimension and a quantization step of each region for each dimension are included. If the quantity of quantization regions is the same for each dimension, only one value may be used for representation.

The compression boundary includes a quantization boundary value for each dimension. Specifically, for each dimension, if the uniform quantization is performed, a maximum quantization boundary value and a minimum quantization boundary value are included; or if the non-uniform quantization is performed, a maximum quantization boundary value and a minimum quantization boundary value of each quantization region are included.

The quantization manner configuration and the quantization step may be pre-agreed upon by the first communication apparatus and the second communication apparatus, or may be pre-sent by the first communication apparatus to the second communication apparatus, or may be pre-sent by the second communication apparatus to the first communication apparatus, or may be defined in a protocol.

The first communication apparatus obtains the compression boundary based on the first data, and sends the compression boundary to the second communication apparatus. Alternatively, a default value is pre-agreed, and the default value is pre-sent by the first communication apparatus to the second communication apparatus, or the default value is pre-sent by the second communication apparatus to the first communication apparatus. For example, in a scenario in which a sensor scanning parameter is fixed, for example, if a scanning distance is constant at 120 m, a boundary value may be constant at 0 to 120, or a horizontal scanning angle may be fixed at 0 degrees to 360 degrees, and a vertical scanning angle may be fixed at -25 degrees to 2 degrees. The foregoing boundary value does not need to change dynamically, and a default value may be used.

The compression processing may further include projection. The first communication apparatus obtains a projection mode configuration, and performs projection based on the projection mode configuration. The projection mode configuration may be pre-agreed upon by the first communication apparatus and the second communication apparatus, or may be pre-sent by the first communication apparatus to the second communication apparatus, or may be pre-sent by the second communication apparatus to the first communication apparatus, or may be defined in a protocol.

The projection may also be referred to as mapping, and is for converting data into different coordinate system representations. Specifically, cylindrical mapping may be used, where one dimension remains unchanged, and the other two dimensions change to polar coordinates. For example, x, y, and z coordinates are mapped to Ø, R, and z coordinates, where $\emptyset=\arccos(x/\sqrt{x^2+y^2})$, and $R=\sqrt{x^2+y^2}$. Alternatively, spherical mapping may be used, where x, y, and z coordinates are mapped to θ, Ø, and r coordinates, where $\theta=\arcsin(z/\sqrt{x^2+y^2+z^2})$, $\emptyset=\arccos(x/\sqrt{x^2+y^2})$, and $r=\sqrt{x^2+y^2+z^2}$. Alternatively, planar mapping may be used to project x, y, and z coordinates onto an XOY/XOZ/YOZ coordinate system plane. Optionally, rotation deformation and/or translation deformation may be further performed on the x, y, and z coordinates before the projection. For example, for irregular data, for example, self-driving data, a better compression effect can be achieved by performing spherical mapping, and cylindrical mapping may be used for identifying and detecting data. Data is converted into a form needed by a scenario or a task, so that compression and transmission efficiency can be improved.

Coding and compression may further be performed on the second data. The coding and compression may include: a JPEG, arithmetic coding (Arithmetic coding, AC), an LZMA (Lempel-Ziv Markov chain Algorithm) compression algorithm, and neural network compression. The first communication apparatus obtains a coding and compression manner configuration, and performs compression based on the coding and compression manner configuration. The coding and compression manner configuration may be pre-agreed upon by the first communication apparatus and the second communication apparatus, or may be pre-sent by the first communication apparatus to the second communication apparatus, or may be pre-sent by the second communication apparatus to the first communication apparatus, or may be defined in a protocol. The coding and compression manner configuration includes selection of a compression manner and a corresponding parameter. For example, if a JPEG manner is selected, a parameter QP needed by the JPEG manner is included.

Each map/each sequence may be compressed, and different coding and compression manners may be selected depending on whether the map is coherent, a degree of sparseness, a data range, an amount of data, and the like. This may further reduce the amount of data.

Optionally, the first data is divided into blocks based on a value range of one or more dimensions, to obtain one or more pieces of block data. Compression processing is performed on each piece of block data, and different configurations may be used. A coordinate range of each to-be-transmitted block may be obtained based on the compression boundary. For example, for block data with dense points, a larger quantity of values are assigned to quantization space and transmission is performed on a plurality of maps, and for block data with sparse points, a smaller quantity of values are assigned to quantization space and transmission is performed on a small quantity of maps. Optionally, the one or more pieces of block data are selected, and compression processing is separately performed. For example, only a spatial region block for which Ø is equal to 30 degrees to 150 degrees is extracted for compression. Each block has an independent boundary value and independent quantization space. Blocks may be independent of each other and do not overlap. Data may be divided into blocks by sensing characteristics such as density and a distribution region of the data, and then different data forms and coding and compression manners are used, to improve communication efficiency. The first communication apparatus sends a quantity of to-be-transmitted blocks to the second communication apparatus. If compression configurations of the blocks are different, the first communication apparatus separately sends a corresponding compression configuration to the second communication apparatus.

In S230, a process in which the second communication apparatus constructs the first data based on the second data and the compression parameter may also be referred to as a process of restoring the first data. Generally, there is a difference between the first data and data obtained by the second communication apparatus by constructing the first data. A smaller difference between the first data and the data obtained by constructing the first data indicates a smaller data loss in a compression and transmission process. Otherwise, a larger difference indicates a larger data loss.

Optionally, when the first data is point cloud data, the second communication apparatus obtains positioning information and/or rotation matrix information, to construct the first data. The positioning information and/or the rotation matrix information may be sent by the first communication apparatus to the second communication apparatus, or may be sent by the second communication apparatus to the first communication apparatus.

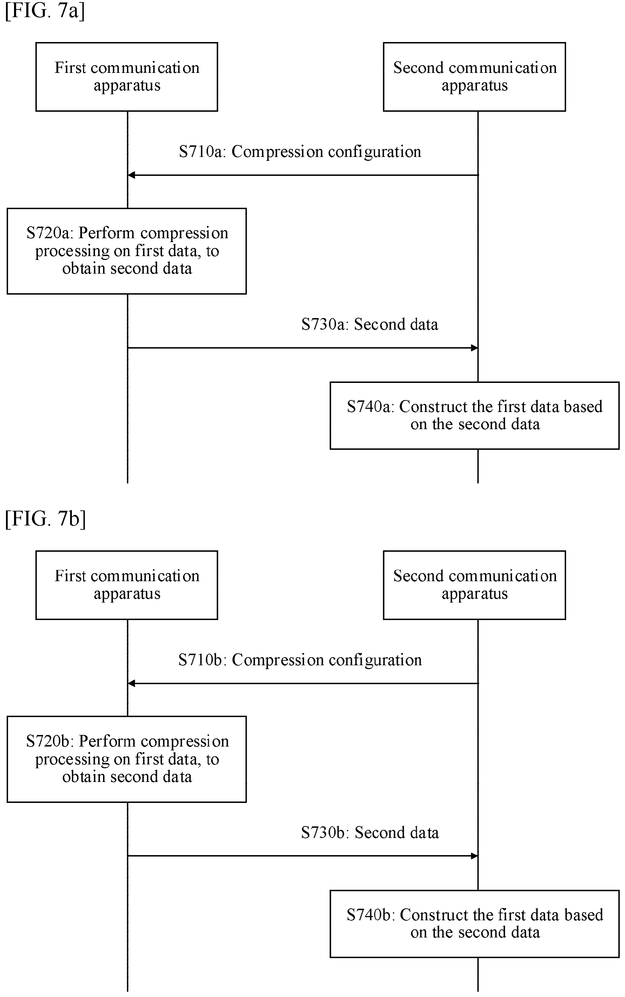

Based on the foregoing embodiments, with reference to FIG. 7a to FIG. 7c, the following describes an example of a manner in which the first communication apparatus and the second communication apparatus implement data compression and transmission through signaling interaction in embodiments of this application.

FIG. 7a is a schematic interaction flowchart of a data compression and transmission method according to an embodiment of this application. The method 700a may include some or all of the following processes.

S710a: A second communication apparatus sends a compression configuration to a first communication apparatus. Correspondingly, the first communication apparatus receives the compression configuration.

S720a: The first communication apparatus performs compression processing on first data, to obtain second data.

S730a: The first communication apparatus sends the second data. Correspondingly, the second communication apparatus receives the second data.

S740a: The second communication apparatus constructs the first data based on the second data.

The foregoing compression configuration may include the foregoing projection mode configuration, quantization manner configuration, quantization step configuration, data form configuration, and coding and compression manner configuration. Some configurations may be obtained through transmission, and other configurations are set to default values and transmission is not needed. The foregoing compression configurations may be separately sent by using separate data streams, or may be combined into one or more data streams for sending. This is not limited in this application.

Optionally, the compression configuration may be sent at a physical layer, or the compression configuration may be carried in a buffer status report (buffer status report, BSR) and sent at a media access control (media access control, MAC) layer.

Optionally, the first communication apparatus may send a first transmission request to the second communication apparatus, and the second communication apparatus sends the compression configuration to the first communication apparatus in response to the first transmission request. Optionally, the first transmission request may be carried in the BSR, to be sent at the MAC layer.

In some communication scenarios, a plurality of rounds of interaction may be performed between the first communication apparatus and the second communication apparatus to complete a communication service. When the plurality of rounds of interaction are performed between the first communication apparatus and the second communication apparatus, in an $m^{th}$ round of interaction process, if a compression configuration does not change, a compression configuration used in an $(m-1)^{th}$ round of interaction process may be shared. For example, if the first communication apparatus receives no compression configuration in the $m^{th}$ round of interaction process, the compression configuration received in the $(m-1)^{th}$ round of interaction process is used as the compression configuration in the $m^{th}$ round of interaction process.

S720a to S740a are similar to the foregoing steps S210 to S230. For brevity, details are not described herein again.

FIG. 7b is a schematic interaction flowchart of a data compression and transmission method according to an embodiment of this application. The method 700b may include some or all of the following processes.

S710b: A first communication apparatus sends a compression configuration to a second communication apparatus. Correspondingly, the second communication apparatus receives the compression configuration sent by the first communication apparatus.

S720b: The first communication performs compression processing on first data, to obtain second data.

S730b: The first communication apparatus sends the second data. Correspondingly, the second communication apparatus receives the second data.

S740b: The second communication apparatus constructs the first data based on the second data.

A difference between the embodiment shown in FIG. 7b and the embodiment shown in FIG. 7a lies in that the first communication apparatus sends the compression configuration to the second communication apparatus according to a data compression solution used by the first communication apparatus, so that the second communication apparatus constructs the first data based on an indication of the compression configuration.

Similar to the embodiment shown in FIG. 7a, the compression configuration may include the foregoing projection mode configuration, quantization manner configuration, quantization step configuration, data form configuration, and coding and compression manner configuration.

Optionally, the first communication apparatus may send the compression configuration before sending the second data, or send the compression configuration together with the second data. This is not limited in this application.

In some embodiments, the first communication apparatus may determine the compression configuration based on a data feature of the first data. For example, sparseness of data may be determined based on a scenario of the first data. The sparseness may be determined based on a scenario or may be determined based on a mathematical definition, for example, based on a ratio of a quantity of grids including points to a total quantity of grids when minimum space/a minimum projection plane including points is divided into a plurality of grids. For a dense point cloud, for example, indoor object scanning, a planar projection manner may be selected. For a sparse point cloud, for example, self-driving street scanning, a spherical projection manner may be selected. In addition, a coding and compression manner may be selected based on sparseness of the second data obtained through the compression processing. If the second data is regular, a JPEG manner may be selected. If the second data is sparse, an LZMA manner or an entropy coding manner may be selected.

In a possible implementation, transmission is performed on the second data in a layered and incremental manner. A transmission resource may be flexibly adapted, and base layer data can also maintain specific performance.

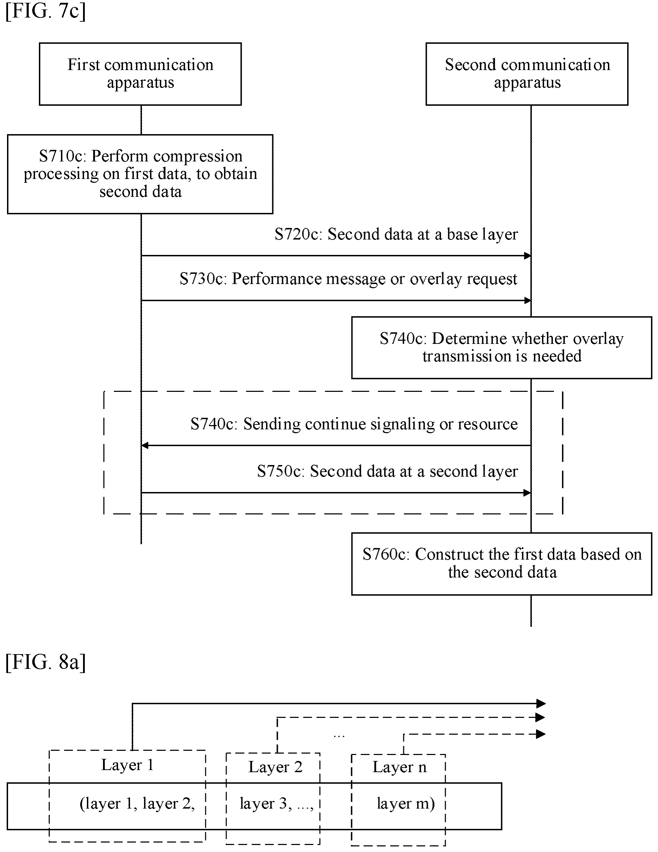

Based on FIG. 7a and FIG. 7b, when transmission is performed on incremental data between the first communication apparatus and the second communication apparatus, some or all of processes in a method 700c shown in FIG. 7c may be further included. FIG. 7c is a schematic interaction flowchart of a data compression and transmission method according to an embodiment of this application. The method 700c may include the following steps.

S710c: A first communication performs compression processing on first data, to obtain second data.

S720c: The first communication apparatus sends second data at a base layer based on a first transmission resource. Correspondingly, a second communication apparatus receives the second data at the base layer.

The first transmission resource is sent by the second communication apparatus to the first communication apparatus. Alternatively, the first communication apparatus estimates a needed resource, and requests a corresponding resource from the second communication apparatus. The second communication apparatus may determine, based on the request of the first communication apparatus, a transmission resource needed for all second data that needs to be transmitted by the first communication apparatus. The first transmission resource configured by the second communication apparatus for the first communication apparatus when resources are insufficient (or to avoid reducing impact on a communication service) is used only to transmit the base layer data of the second data. The first k pieces of data that do not exceed the first transmission resource are used as the base layer data. When the first transmission resource is sufficient for transmission of all the second data, the base layer data is all the data.

S730c: The first communication apparatus sends overlay transmission information, where the overlay transmission information includes a performance message or an overlay request (or a total quantity of layers). Correspondingly, the second communication apparatus receives the overlay transmission information.

The performance message may represent impact of data reconstruction on a task, for example, target detection and environment reconstruction.

The first communication apparatus may send the overlay transmission information to the second communication apparatus when overlay data needs to be sent, to request incremental transmission.

Optionally, the overlay request may include a data size of the overlay data (or a size of a transmission resource needed by the overlay data). The data size of the overlay data (or the size of the transmission resource needed by the overlay data) may be obtained through calculation in a static or dynamic manner.

Optionally, the overlay request may be carried in a BSR for sending.

Optionally, when the first communication apparatus does not need to send the overlay data (for example, when compression and transmission of the second data have been completed), the first communication apparatus may not send the overlay transmission information, and the second communication apparatus determines, when the overlay transmission information is not received, that the compression and transmission of the second data have been completed. Alternatively, the first communication apparatus may send incremental transmission end signaling to the second communication apparatus, to indicate the second communication apparatus to end the compression and transmission of the second data.

S740c: The second communication apparatus determines, based on the overlay transmission information or a requirement of the second communication apparatus, whether overlay transmission is needed. If overlay transmission is needed, the second communication apparatus sends sending continue signaling or a resource. Correspondingly, the first communication apparatus receives the sending continue signaling or the resource. If overlay transmission is not needed, the second communication apparatus sends transmission terminate signaling to the first communication apparatus, or performs no operation. For example, the second communication apparatus may analyze, based on the constructed first data, whether construction performance meets a service requirement. When the construction performance meets the service requirement, incremental transmission is not needed. When the construction performance does not meet the service requirement, incremental transmission is needed.

A sending occasion for the sending continue signaling or the resource is not limited in this application. For example, the second communication apparatus may send the sending continue signaling or the resource in response to the overlay transmission information sent by the first communication apparatus. Alternatively, the second communication apparatus may send the sending continue signaling or the resource to the first communication apparatus when determining that the construction performance for constructing the first data is poor.

S750c: The first communication apparatus sends second data at a second layer based on the sending continue signaling or the resource. Correspondingly, the second communication apparatus receives the second data at the second layer.

S760c: The second communication apparatus constructs the first data based on the second data at the base layer and the second data at the second layer.

Optionally, compression processing may be performed on the second data at the second layer by using a different compression configuration, to obtain better performance and a high compression ratio. The compression configuration includes the foregoing projection mode configuration, quantization manner configuration, quantization step configuration, data form configuration, and coding and compression manner configuration. The first communication apparatus sends a changed compression configuration to the second communication apparatus.

For example, data at the base layer is dense, and a JPEG manner may be selected for compression. Data at the second layer is sparse, and an entropy coding manner may be configured for compression.

The second data at the second layer may alternatively be re-quantized based on a compression boundary of a current layer, and the first communication apparatus sends the compression boundary to the second communication apparatus. When the compression boundary of the current layer has a small range, a large quantity of transmission resources can be saved.

It should be understood that, after the second data at the base layer is sent, when a remaining amount of second data is still large, the second data may be divided into a plurality of layers, and steps S730c to S750c are repeated to send the data for a plurality of times until all the data is transmitted or a requirement is met.

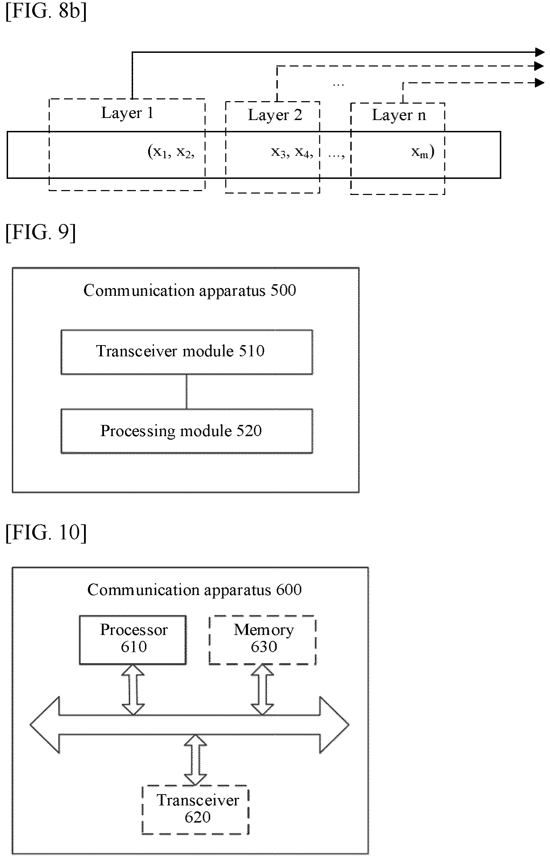

For example, refer to FIG. 8a. The second data is represented by using m layers, where a layer 1 and a layer 2 are used as base layer data for transmission, a layer 3 is used as a $2^{nd}$ layer data for transmission, ..., and a layer m is used as an $n^{th}$ layer data for transmission. In another example, refer to FIG. 8b. The second data is represented by using m sequences, where $x_1$ and $x_2$ are used as base layer data for transmission, $x_3$ and $x_4$ are used as a $2^{nd}$ layer data for transmission, ..., and $x_m$ is used as an $n^{th}$ layer data for transmission.

To implement functions in the foregoing method provided in embodiments of this application, the first communication apparatus and the second communication apparatus each may include a hardware structure and/or a software module. The foregoing functions are implemented in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions.

As shown in FIG. 9, an embodiment of this application provides a communication apparatus 500. The communication apparatus 500 may be a terminal or a network device, an apparatus in the terminal device or the network device, or an apparatus that can be used in combination with the terminal device and the network device. In a possible implementation, the communication apparatus 500 may include modules or units that perform the methods/operations/-steps/actions performed by the first communication apparatus or the second communication apparatus in the foregoing method embodiments and that are in one-to-one correspondence with the foregoing methods/operations/steps/actions. The units may be implemented by a hardware circuit, software, or a combination of the hardware circuit and the software. In a possible implementation, the communication apparatus 500 may include a transceiver module 510 and a processing module 520. The processing module 520 may be configured to invoke the transceiver module 510 to perform a receiving and/or sending function.

Optionally, the communication apparatus 500 may correspond to the first communication apparatus in the foregoing method embodiments.

It should be understood that the communication apparatus 500 may include modules that perform the method on a first communication apparatus side in the methods in embodiments of this application. In addition, the modules in the communication apparatus 500 and the foregoing other operations and/or functions are separately used to implement corresponding procedures of the methods.

When the communication apparatus 500 is configured to perform the method on the first communication apparatus side, the processing module 520 may be configured to perform compression processing on P-dimensional first data, to obtain Q-dimensional second data, where P is an integer greater than 1, and Q is less than P. The transceiver module 510 may be configured to send the second data to a second communication apparatus.

It should be understood that a specific process performed by the modules is described in detail in the foregoing method embodiments. For brevity, details are not described herein again.

Optionally, the communication apparatus 500 may correspond to the second communication apparatus in the foregoing method embodiments.

It should be understood that the communication apparatus 500 may include modules that perform the method on a second communication apparatus side in the methods in embodiments of this application. In addition, the modules in the communication apparatus 500 and the foregoing other operations and/or functions are separately used to implement corresponding procedures of the methods.

When the communication apparatus 500 is configured to perform the method on the second communication apparatus side, the transceiver module 510 may be configured to receive second data from a first communication apparatus, where the second data is obtained by performing compression processing on first data. The processing module 520 may be configured to construct the first data based on the second data.

It should be understood that a specific process performed by the modules is described in detail in the foregoing method embodiments. For brevity, details are not described herein again.

The transceiver module 510 in the communication apparatus 500 may be implemented as a transceiver, for example, may correspond to a transceiver 620 in a communication apparatus 600 shown in FIG. 10. The processing module 520 in the communication apparatus 500 may be implemented as at least one processor, for example, may correspond to a processor 610 in the communication apparatus 600 shown in FIG. 10.

When the communication apparatus 500 is a chip or a chip system configured in a communication device (like a terminal device or a network device), the transceiver unit 510 in the communication apparatus 500 may be implemented as an input/output interface, a circuit, or the like, and the processing unit 520 in the communication apparatus 500 may be implemented as a processor, a microprocessor, an integrated circuit, or the like integrated in the chip or the chip system.

FIG. 10 is another block diagram of a communication apparatus according to an embodiment of this application. As shown in FIG. 10, the communication apparatus 600 may include a processor 610. The processor 610 may be configured to perform the method performed by the first communication apparatus or the second communication apparatus in the foregoing method embodiments.

In some possible implementations, the communication apparatus 600 may include a transceiver 620. The transceiver 620 and the processor 610 may communicate with each other through an internal connection path. The processor 610 may control the transceiver 620 to send a signal and/or receive a signal.

In some possible implementations, the communication apparatus 600 may include a memory 630. The memory 630 and the processor 610 may communicate with each other through an internal connection path. The memory 630 and the processor 610 may be integrated together, or disposed separately. The memory 630 may alternatively be a memory outside the apparatus. The memory 630 is configured to store instructions, and the processor 610 is configured to execute the instructions stored in the memory 630, to perform the method in the foregoing method embodiments.

It should be understood that the communication apparatus 600 may correspond to the first communication apparatus or the second communication apparatus in the foregoing method embodiments, and may be configured to perform each step and/or procedure performed by the first communication apparatus or the second communication apparatus in the foregoing method embodiments. Optionally, the memory 630 may include a read-only memory and a random access memory, and provide instructions and data for the processor. A part of the memory may further include a non-volatile random access memory. The memory 630 may be a separate component, or may be integrated into the processor 610. The processor 610 may be configured to execute the instructions stored in the memory 630. When the processor 610 executes the instructions stored in the memory, the processor 610 is configured to perform each step and/or procedure in the foregoing method embodiments corresponding to the first communication apparatus or the second communication apparatus.

Optionally, the communication apparatus 600 is the first communication apparatus in the foregoing embodiments.

Optionally, the communication apparatus 600 is the second communication apparatus in the foregoing embodiments.

The transceiver 620 may include a transmitter and a receiver. The transceiver 620 may further include an antenna. There may be one or more antennas. The processor 610, the memory 630, and the transceiver 620 may be components integrated into different chips. For example, the processor 610 and the memory 630 may be integrated into a baseband chip, and the transceiver 620 may be integrated into a radio frequency chip. Alternatively, the processor 610, the memory 630, and the transceiver 620 may be components integrated into a same chip. This is not limited in this application.

The transceiver 620 may alternatively be a communication interface, for example, an input/output interface or a circuit.

It should be understood that the foregoing communication apparatus may be one or more chips. For example, the communication apparatus may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable logic device (programmable logic device, PLD), or another integrated chip.

In an implementation process, steps in the foregoing methods can be completed by a hardware integrated logic circuit in a processor, or by using instructions in a form of software. The steps of the method disclosed with reference to embodiments of this application may be directly performed and completed by a hardware processor, or may be performed and completed by a combination of hardware in the processor and a software module. The software module may be located in a mature storage medium in the art, such as a random access memory, a flash memory, a read-only memory, a programmable read-only memory, an electrically erasable programmable memory, or a register. The storage medium is located in a memory, and the processor reads information in the memory and completes the steps in the foregoing method in combination with hardware of the processor. To avoid repetition, details are not described herein again.

It may be understood that the memory in embodiments of this application may be a volatile memory or a nonvolatile memory, or may include a volatile memory and a nonvolatile memory.

According to the method provided in embodiments of this application, this application further provides a computer program product. The computer program product includes a computer program or a set of instructions. When the computer program or the set of instructions are run on a computer, the computer is enabled to perform the method performed by the first communication apparatus or the second communication apparatus in the foregoing method embodiments.

According to the method provided in embodiments of this application, this application further provides a computer-readable storage medium. The computer-readable storage medium stores a program. When the program is run on a computer, the computer is enabled to perform the method performed by the first communication apparatus or the second communication apparatus in the foregoing method embodiments.

According to the method provided in embodiments of this application, this application further provides a communication system. The communication system may include the foregoing first communication apparatus or second communication apparatus.

Functional units in embodiments of this application may be integrated into one processing unit, each of the units may exist alone physically, or two or more units are integrated into one unit.

When a function is implemented in a form of a software functional unit and sold or used as an independent product, the function may be stored in a computer-readable storage medium. Based on such an understanding, a part contributing to the technical solutions in this application, or a part of the technical solutions may be embodied in a form of a software product. The computer software product is stored in a storage medium, and includes several instructions for instructing a computer device (which may be a personal computer, a server, a network device, or the like) to perform all or some steps of the methods in embodiments of this application. The foregoing storage medium includes any medium that can store program code, such as a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

**Claims**

1.  A data compression and transmission method, comprising:

    performing compression processing on P-dimensional first data, to obtain Q-dimensional second data, wherein P is an integer greater than 1, and Q is less than P; and
    sending the second data.

2.  The method according to claim 1, wherein the compression processing comprises: using Q-dimensional data in the first data as position information and remaining (P-Q)-dimensional data as value information, to obtain the second data based on the position information and the value information.

3.  The method according to claim 2, wherein the compression processing further comprises:

    obtaining a data form configuration, and representing the second data based on the data form configuration, wherein
    the data form comprises:

    the position information and the value information are jointly represented by using a first value map; or
    the position information is represented by using a position sequence or a position bitmap, wherein the position sequence indicates a position at which data exists or a position at which no data exists, and the position bitmap indicates whether each position has value information; and the value information is represented by using a value sequence corresponding to the position information or a second value map in which the corresponding position information is used as coordinates.

4.  The method according to claim 3, wherein the second value map further comprises: a position without value information is filled with an interpolated value.

5.  The method according to claim 3 or 4, wherein a maximum of N pieces of value information exist at a same position, N is an integer greater than 1, and the data form further comprises:

    the position information and the value information are jointly represented by using N first value maps, wherein an $i^{th}$ first value map is for recording an $i^{th}$ piece of value information and corresponding position information, and i=1, 2, ..., N; or
    the position information is represented by using N position sequences or bitmaps, wherein an $i^{th}$ position sequence or bitmap is for recording position information of an $i^{th}$ piece of value information, or the position information is represented by using a value information quantity map for recording a value information quantity at each position; and the value information is represented by using N second value maps, wherein an $i^{th}$ second value map is for recording the $i^{th}$ piece of value information, or the value information is represented by using a value sequence corresponding to the position information.

6. The method according to any one of claims 1 to 5, wherein the compression processing further comprises: obtaining a quantization manner configuration, a quantization step configuration, and a compression boundary; and performing quantization based on the quantization manner configuration, the quantization step configuration, and the compression boundary.

7. The method according to claim 6, wherein the compression boundary is generated based on the first data, and the compression boundary is sent.

8. The method according to claim 6 or 7, wherein the quantization manner configuration comprises an indication of uniform quantization or non-uniform quantization for each dimension; and correspondingly, if the quantization manner configuration is the uniform quantization, the quantization step configuration comprises a quantization step for each dimension; or if the quantization manner configuration is the non-uniform quantization, the quantization step configuration comprises a quantity of quantization regions for each dimension and a quantization step of each region for each dimension.

9. The method according to any one of claims 1 to 8, wherein the compression processing further comprises: obtaining a projection mode configuration; and performing projection based on the projection mode configuration.

10. The method according to any one of claims 1 to 9, wherein the method further comprises: obtaining a coding and compression manner configuration; and performing coding and compression on the second data based on the coding and compression manner configuration.

11. The method according to any one of claims 1 to 10, wherein the method further comprises: dividing the first data into blocks based on a value range of one or more dimensions, to obtain U pieces of block data, wherein U is an integer greater than 1; and separately performing compression processing on V pieces of block data, wherein V is less than or equal to U.

12. The method according to any one of claims 1 to 11, wherein sending the second data comprises: sending base layer data based on a base layer transmission resource, wherein the base layer data is a part of the second data that does not exceed a size of the base layer transmission resource.

13. The method according to claim 12, wherein the second data is represented by using L maps or sequences, L is an integer greater than 1, the base layer data comprises K maps or sequences, and K is less than or equal to L.

14. The method according to claim 12 or 13, wherein sending the second data further comprises: sending overlay transmission information.

15. The method according to claim 14, wherein the overlay transmission information comprises a performance message or an overlay request.

16. The method according to any one of claims 12 to 15, wherein sending the second data further comprises: sending overlay data based on sending continue signaling, wherein the overlay data is a part or all of data other than the base layer data in the second data.

17. The method according to claim 16, wherein sending the overlay data further comprises: compressing the overlay data by using a different configuration.

18. A data processing method, comprising:

receiving Q-dimensional second data; and
constructing the first data based on the second data, wherein
the Q-dimensional second data is obtained by performing compression processing on the P-dimensional first data; and

P is an integer greater than 1, and Q is less than P.

19. The method according to claim 18, wherein the compression processing comprises: using Q-dimensional data in the first data as position information and remaining (P-Q)-dimensional data as value information, to obtain the second data based on the position information and the value information.

20. The method according to claim 19, wherein the compression processing further comprises:

obtaining a data form configuration, and representing the second data based on the data form configuration, wherein
the data form comprises:

the position information and the value information are jointly represented by using a first value map; or
the position information is represented by using a position sequence or a position bitmap, wherein the position sequence indicates a position at which data exists or a position at which no data exists, and the position bitmap indicates whether each position has value information; and the value information is represented by using a value sequence corresponding to the position information or a second value map in which the corresponding position information is used as coordinates.

21. The method according to claim 20, wherein the second value map further comprises: a position without value information is filled with an interpolated value.

22. The method according to claim 20 or 21, wherein a maximum of N pieces of value information exist at a same position, N is an integer greater than 1, and obtaining the second data based on the position information and the value information further comprises:

the position information and the value information are jointly represented by using N first value maps, wherein an $i^{th}$ first value map is for recording an $i^{th}$ piece of value information and corresponding position information, and i=1, 2, ..., N; or
the position information is represented by using N position sequences or bitmaps, wherein an $i^{th}$ position sequence or bitmap is for recording position information of an $i^{th}$ piece of value information, or the position information is represented by using a value information quantity map for recording a value information quantity at each position; and the value information is represented by using N second value maps, wherein an $i^{th}$ second value map is for recording the $i^{th}$ piece of value information, or the value information is represented by using a value sequence corresponding to the position information.

23. The method according to any one of claims 18 to 22, wherein the compression processing further comprises: obtaining a quantization manner configuration, a quantization step configuration, and a compression boundary; and performing quantization based on the quantization manner configuration, the quantization step configuration, and the compression boundary.

24. The method according to claim 23, wherein the compression boundary is generated based on the first data, and the compression boundary is received.

25. The method according to claim 23 or 24, wherein the quantization manner configuration comprises an indication of uniform quantization or non-uniform quantization for each dimension; and correspondingly, if the quantization manner configuration is the uniform quantization, the quantization step configuration comprises a quantization step for each dimension, or if the quantization manner configuration is the non-uniform quantization, the quantization step configuration comprises a quantity of quantization regions for each dimension and a quantization step of each region for each dimension.

26. The method according to any one of claims 18 to 25, wherein the compression processing further comprises: obtaining a projection mode configuration; and performing projection based on the projection mode configuration.

27. The method according to any one of claims 18 to 26, wherein the method further comprises: obtaining a coding and compression manner configuration; and performing coding and compression on the second data based on the coding and compression manner configuration.

28. The method according to any one of claims 18 to 27, wherein the method further comprises: dividing the first data into blocks based on a value range of one or more dimensions, to obtain U pieces of block data, wherein U is an integer greater than 1; and separately performing compression processing on V pieces of block data, wherein V is less than or equal to U.

29. The method according to any one of claims 18 to 28, wherein the method further comprises: receiving base layer data that is sent based on a base layer transmission resource, wherein the base layer data is a part of the second data that does not exceed a size of the base layer transmission resource.

30. The method according to claim 29, wherein the second data is represented by using L maps or sequences, L is an integer greater than 1, the base layer data comprises K maps or sequences, and K is less than or equal to L.

31. The method according to claim 29 or 30, wherein the method further comprises: receiving overlay transmission information.

32. The method according to claim 31, wherein the overlay transmission information comprises a performance message or an overlay request.

33. The method according to claim 31 or 32, wherein the method further comprises: determining, based on the overlay transmission information or a requirement, whether overlay transmission is needed; and if overlay transmission is needed, sending sending continue signaling or a resource; or if overlay transmission is not needed, sending transmission terminate signaling, or performing no operation.

34. The method according to any one of claims 29 to 33, wherein the method further comprises: receiving overlay data, wherein the overlay data is a part or all of data other than the base layer data in the second data.

35. A communication apparatus, comprising a module configured to perform the method according to any one of claims 1 to 17 or a module configured to perform the method according to any one of claims 18 to 34.

36. A communication apparatus, comprising a processor, wherein the processor is configured to perform the method according to any one of claims 1 to 34 by running a computer program or by using a logic circuit.

37. The apparatus according to claim 36, further comprising a memory, wherein the memory is configured to store the computer program.

38. The apparatus according to claim 36 or 37, further comprising a communication interface, wherein the communication interface is configured to input and/or output a signal.

39. A communication system, comprising a first communication apparatus configured to perform the method according to any one of claims 1 to 17 and a second communication apparatus configured to perform the method according to any one of claims 18 to 34.

40. A computer-readable storage medium, configured to store computer program instructions, wherein the computer program enables a computer to perform the method according to any one of claims 1 to 34.

41. A computer program product, comprising computer program instructions, wherein the computer program instructions enable a computer to perform the method according to any one of claims 1 to 34.

[FIG. 1]

100

[FIG. 2]

| Terminal device 130 | | |
|---|---|---|
| Physical layer data | Data compression | |

| Network device 120 | | |
|---|---|---|
| Data decompression | Restored data | |

| Physical layer data | Data compression | |
|---|---|---|

| Data decompression | Restored data | |
|---|---|---|

Terminal device 140

[FIG. 3]

First communication apparatus

Second communication apparatus

S210: Perform compression processing on first data, to obtain second data

S220: Second data

S230: Construct the first data based on the second data

[FIG. 4]

| | | | | |
|---|---|---|---|---|
| 0 | 0 | 1 | 1 | 1 |
| 1 | 1 | 1 | 1 | 1 |
| 1 | 1 | 0 | 0 | 1 |
| 1 | 1 | 1 | 1 | 1 |
| 0 | 1 | 0 | 1 | 1 |
| 1 | 1 | 1 | 1 | 0 |

[FIG. 5]

| | | | | |
|---|---|---|---|---|
| 0 | 0 | 4 | 2 | 3 |
| 2 | 4 | 5 | 7 | 1 |
| 1 | 7 | 0 | 0 | 3 |
| 4 | 5 | 7 | 1 | 1 |
| 0 | 7 | 0 | 6 | 4 |
| 4 | 4 | 7 | 2 | 0 |

[FIG. 6]

| | | | | |
|---|---|---|---|---|
| 0 | 0 | 2 | 1 | 3 |
| 1 | 1 | 1 | 1 | 2 |
| 1 | 2 | 0 | 0 | 1 |
| 1 | 1 | 2 | 1 | 1 |
| 0 | 1 | 0 | 1 | 2 |
| 3 | 1 | 1 | 2 | 0 |

[FIG. 7a]

```
┌──────────────────────┐              ┌──────────────────────┐
│  First communication │              │ Second communication │
│      apparatus       │              │      apparatus       │
└──────────────────────┘              └──────────────────────┘
          │                                      │
          │     S710a: Compression configuration │
          │◄─────────────────────────────────────│
          │                                      │
┌──────────────────────────┐                     │
│ S720a: Perform compression│                    │
│ processing on first data, to│                  │
│   obtain second data     │                     │
└──────────────────────────┘                     │
          │          S730a: Second data          │
          │─────────────────────────────────────►│
          │                                      │
          │                  ┌──────────────────────────────┐
          │                  │ S740a: Construct the first data based│
          │                  │      on the second data      │
          │                  └──────────────────────────────┘
          │                                      │
```

[FIG. 7b]

```
┌──────────────────────┐              ┌──────────────────────┐
│  First communication │              │ Second communication │
│      apparatus       │              │      apparatus       │
└──────────────────────┘              └──────────────────────┘
          │                                      │
          │     S710b: Compression configuration │
          │◄─────────────────────────────────────│
          │                                      │
┌──────────────────────────┐                     │
│ S720b: Perform compression│                    │
│ processing on first data, to│                  │
│   obtain second data     │                     │
└──────────────────────────┘                     │
          │          S730b: Second data          │
          │─────────────────────────────────────►│
          │                                      │
          │                  ┌──────────────────────────────┐
          │                  │ S740b: Construct the first data based│
          │                  │      on the second data      │
          │                  └──────────────────────────────┘
          │                                      │
```

[FIG. 7c]

| First communication apparatus | | Second communication apparatus |
|---|---|---|

S710c: Perform compression processing on first data, to obtain second data

S720c: Second data at a base layer

S730c: Performance message or overlay request

S740c: Determine whether overlay transmission is needed

S740c: Sending continue signaling or resource

S750c: Second data at a second layer

S760c: Construct the first data based on the second data

[FIG. 8a]

| Layer 1 | Layer 2 | ... | Layer n |
|---|---|---|---|

(layer 1, layer 2,     layer 3, ...,     layer m)

[FIG. 8b]

| | Layer 1 | | Layer 2 | ... | Layer n | |
|---|---|---|---|---|---|---|
| | $(x_1, x_2,$ | | $x_3, x_4,$ | ..., | $x_m)$ | |

[FIG. 9]

Communication apparatus 500

Transceiver module 510

Processing module 520

[FIG. 10]

Communication apparatus 600

Processor 610

Memory 630

Transceiver 620

## INTERNATIONAL SEARCH REPORT

| International application No. |
|---|
| **PCT/CN2023/082281** |

**A. CLASSIFICATION OF SUBJECT MATTER**

H04W28/06(2009.01)i; H04W72/04(2023.01)i

According to International Patent Classification (IPC) or to both national classification and IPC

**B. FIELDS SEARCHED**

Minimum documentation searched (classification system followed by classification symbols)

IPC: H04W

Documentation searched other than minimum documentation to the extent that such documents are included in the fields searched

Electronic data base consulted during the international search (name of data base and, where practicable, search terms used)

CNABS; CNTXT; VEN; EPTXT; USTXT; WOTXT; CNKI: 压缩, 降维, 维度, 量化, 投影, 位置, 数值, 序列; compress, dimension, reduction, quantify, projection, position, sequence

**C. DOCUMENTS CONSIDERED TO BE RELEVANT**

| Category* | Citation of document, with indication, where appropriate, of the relevant passages | Relevant to claim No. |
|---|---|---|
| X | US 8811156 B1 (RAYTHEON CO.) 19 August 2014 (2014-08-19) description, column 2, line 53 to column 9, line 42, and figures 1-2 | 1-41 |
| X | US 2022149904 A1 (TELEFONAKTIEBOLAGET LM ERICSSON (PUBL)) 12 May 2022 (2022-05-12) description, paragraphs [0068]-[0069] and [0125]-[0347], and figure 9 | 1-41 |
| A | CN 111757382 A (HUAWEI TECHNOLOGIES CO., LTD.) 09 October 2020 (2020-10-09) entire document | 1-41 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **22 November 2023** | **23 November 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/082281**

| Patent document cited in search report | | | Publication date (day/month/year) | Patent family member(s) | | | Publication date (day/month/year) |
|---|---|---|---|---|---|---|---|
| US | 8811156 | B1 | 19 August 2014 | None | | | |
| US | 2022149904 | A1 | 12 May 2022 | WO | 2020180221 | A1 | 10 September 2020 |
| | | | | US | 11509363 | B2 | 22 November 2022 |
| | | | | EP | 3935742 | A1 | 12 January 2022 |
| | | | | EP | 3935742 | A4 | 19 October 2022 |
| | | | | US | 2022376749 | A1 | 24 November 2022 |
| | | | | US | 11728851 | B2 | 15 August 2023 |
| CN | 111757382 | A | 09 October 2020 | CN | 111757382 | B | 13 May 2022 |

Form PCT/ISA/210 (patent family annex) (July 2022)